# EUROPÄISCHE PATENTANMELDUNG

(11) **EP 3 879 423 A1**
(43) Veröffentlichungstag der Anmeldung: **15.09.2021**
(21) Anmeldenummer: 20163054.8
(22) Anmeldetag: 13.03.2020
(51) Int. Cl.: G06F 30/13, G06F 30/20

(54) **VERFAHREN UND VORRICHTUNG ZUM GENERIEREN VON DIGITALEN MODELLANSICHTEN FÜR BAUWERKE**

(71) Anmelder: Siemens Schweiz AG, 8047 Zürich (CH)
(72) Erfinder: MAYER, Hermann Georg, 83209 Prien am Chiemsee (DE); ZECHLIN, Oliver, 6300 Zug (CH)
(74) Vertreter: Maier, Daniel Oliver

(57) **Zusammenfassung**

Computerimplementiertes Verfahren zum Generieren von digitalen Modellansichten (RMV) für ein Bauwerk, wobei ein digitales Bauwerksmodell (BM) des Bauwerks eingelesen wird, aus dem digitalen Bauwerksmodell (BM) Bauwerkselementangaben (BEI, BE2) über Bauwerkselemente und Beziehungsangaben (BA) über Beziehungen zwischen Bauwerkselementen extrahiert und gemäß einer jeweiligen Beziehung einander zugeordnet gespeichert werden . Weiterhin werden unterschiedlichen, zur Bündelung von Rechten, Funktionen oder Eigenschaften von Benutzern (USR) oder Applikationen (APP) vorgesehenen Rollen (R1, R2) jeweils eine oder mehrere Bauwerkselementangaben (BE1, BE2) zugeordnet. Bei Anforderung einer Modellansicht (RMV) wird dann eine der Anforderung zugeordnete Rolle (R1) ermittelt, und es werden diejenigen gespeicherten Bauwerkselementangaben (BE1, BE2) als rollenspezifische Bauwerkselementangaben selektiert, die der ermittelten Rolle (R1) zugeordnet sind. Mit den selektierten, rollenspezifischen Bauwerkselementangaben (BE1, BE2) und den diesen zugeordneten Beziehungsangaben wird dann eine rollenspezifische digitale Modellansicht (RMV) generiert und ausgegeben.

## Beschreibung

Die Erstellung von Bauwerken erfolgt in der Regel anhand eines Bauplans oder eines digitalen Bauwerksmodells, insbesondere anhand eines sogenannten BIM-Modells (BIM: Building Information Model). Darüber hinaus werden häufig auch zweckspezifische Ansichten von Bauplänen oder Bauwerksmodellen benötigt, so z.B. für Fluchtpläne, Reinigungspläne, Belegungspläne, Brandschutzpläne, Mobiliarpläne, Roboterwege, Energiesimulationen oder zur Beurteilung einer Mobilnetz- oder WLAN-Abdeckung. Diese spezifischen und oft sehr unterschiedlichen Modellansichten werden in der Regel anhand der verfügbaren Baupläne oder Bauwerksmodelle erstellt, gewartet und ggf. versioniert. Dabei kommt es allerdings häufig zu redundanten Darstellungen von Bauwerkselementen, was eine spätere Konsolidierung der Modellansichten erschwert, falls die Baupläne oder die Bauwerksmodelle verändert werden. Zudem ist es oft schwierig, unterschiedliche Modellansichten auf einem aktuellen Stand zu halten, falls sich Bauwerkselemente des Bauwerks über die Zeit ändern. Aus diesen Gründen sind Erstellung und Wartung derartiger zweckspezifischer Modellansichten häufig mit hohem manuellem Aufwand verbunden.

Es ist Aufgabe der vorliegenden Erfindung ein Verfahren und eine Vorrichtung anzugeben, durch die sich digitale Modellansichten mit größerer Flexibilität und/oder mit geringerem Aufwand generieren lassen.

Gelöst wird diese Aufgabe durch ein Verfahren mit den Merkmalen des Patentanspruchs 1, durch eine Vorrichtung mit den Merkmalen des Patentanspruchs 13, durch ein Computerprogrammprodukt mit den Merkmalen des Patentanspruchs 14 sowie durch ein computerlesbares Speichermedium mit den Merkmalen des Patentanspruchs 15.

Zum Generieren von digitalen Modellansichten für ein Bauwerk wird ein digitales Bauwerksmodell des Bauwerks eingelesen. Ein solches Bauwerk kann insbesondere ein öffentliches oder privates Gebäude, ein Wohngebäude, ein Bürogebäude, ein Fabrikgebäude, ein Kraftwerk, ein Tunnel, eine Brücke, eine Straße oder eine andere bauliche Konstruktion sein. Die digitalen Modellansichten können insbesondere durch Datensätze oder andere Datenstrukturen mit Angaben über visuell, akustisch und/oder haptisch wiederzugebende Bauwerksstrukturen implementiert werden. Aus dem digitalen Bauwerksmodell werden Bauwerkselementangaben über Bauwerkselemente und Beziehungsangaben über Beziehungen zwischen Bauwerkselementen extrahiert und gemäß einer jeweiligen Beziehung einander zugeordnet gespeichert. Erfindungsgemäß werden unterschiedlichen, zur Bündelung von Rechten, Funktionen oder Eigenschaften von Benutzern oder Applikationen vorgesehenen Rollen jeweils eine oder mehrere Bauwerkselementangaben zugeordnet. Bei Anforderung einer Modellansicht wird dann eine der Anforderung zugeordnete Rolle ermittelt, und es werden diejenigen gespeicherten Bauwerkselementangaben als rollenspezifische Bauwerkselementangaben selektiert, die der ermittelten Rolle zugeordnet sind. Mit den selektierten, rollenspezifischen Bauwerkselementangaben und den diesen zugeordneten Beziehungsangaben wird dann eine rollenspezifische digitale Modellansicht generiert und ausgegeben.

Zum Ausführen des erfindungsgemäßen Verfahrens sind eine Vorrichtung zum Generieren von digitalen Modellansichten, ein Computerprogrammprodukt sowie ein computerlesbares, vorzugsweise nichtflüchtiges Speichermedium vorgesehen.

Das erfindungsgemäße Verfahren, die erfindungsgemäße Vorrichtung sowie das erfindungsgemäße Computerprogrammprodukt können insbesondere mittels eines oder mehrerer Computer, eines oder mehrerer Prozessoren, anwendungsspezifischer integrierter Schaltungen (ASIC), digitaler Signalprozessoren (DSP), einer Cloud-Infrastruktur und/oder sogenannter "Field Programmable Gate Arrays" (FPGA) ausgeführt werden.

Die Erfindung erlaubt es, eine Vielzahl spezifischer Modellansichten mit verhältnismäßig geringem Aufwand zu generieren und/oder an unterschiedliche, rollenspezifische Zwecke anzupassen. Insbesondere können die Modellansichten automatisch an ganze Bündel von benutzer- oder applikationsspezifischen Rechten, Funktionen oder Eigenschaften angepasst werden.

Vorteilhafte Ausführungsformen und Weiterbildungen der Erfindung sind in den abhängigen Ansprüchen angegeben.

Gemäß einer vorteilhaften Weiterbildung der Erfindung kann geprüft werden, ob zu einer jeweiligen Bauwerkselementangabe oder Beziehungsangabe eine weitere Bauwerkselementangabe und/oder eine weitere Beziehungsangabe in einer Datenbank hinterlegt ist. Falls dies zutrifft, kann die weitere Bauwerkselementangabe und/oder weitere Beziehungsangabe eingelesen und der jeweiligen Bauwerkselementangabe oder Beziehungsangabe zugeordnet gespeichert werden. Die Zuordnung einer Bauwerkselementangabe oder Beziehungsangabe zu einer weiteren Bauwerkselementangabe und/oder weiteren Beziehungsangabe kann dabei insbesondere durch eine neue Beziehungsangabe dargestellt werden. Auf diese Weise können die im Bauwerksmodell enthaltenen Angaben durch zusätzliche Planungsangaben aus ggf. unterschiedlichen Quellen erweitert werden. So kann beispielsweise ein Fenster im Bauwerksmodell um verschiedene in einer Datenbank hinterlegte Ansichten oder Versionen des Fensters, ggf. in unterschiedlichen Detailierungsstufen ergänzt werden.

Nach einer vorteilhaften Ausführungsform der Erfindung können die Bauwerkselementangaben als Knoten und die Beziehungsangaben als Kanten in einem Knowledge-Graphen gespeichert werden. Ein solcher Knowledge-Graph kann dabei insbesondere als Datenstruktur implementiert werden, in der Datensätze als Knoten und darin enthaltene Verweise zu anderen Datensätzen als Kanten fungieren. Durch die Knoten und Kanten können auf einfache Weise Zuordnungen zwischen Bauwerkselementangaben bzw. Beziehungsangaben definiert werden.

Vorzugsweise kann ein die selektierten, rollenspezifischen Bauwerkselementangaben und die diesen zugeordneten Beziehungsangaben enthaltender Teilgraph des Knowledge-Graphen erzeugt werden. Anhand des erzeugten Teilgraphen kann dann die rollenspezifische digitale Modellansicht generiert werden. Insbesondere kann dabei ein Teilgraph erzeugt werden, der keine nichtselektierten Bauwerkselementangaben enthält.

Weiterhin kann geprüft werden, ob einer im Teilgraphen enthaltenen Beziehungsangabe eine nichtselektierte Bauwerkselementangabe zugeordnet ist. Falls dies zutrifft, kann anstelle des Knotens mit der nichtselektierten Bauwerkselementangabe ein Knoten ohne die nichtselektierte Bauwerkselementangabe in den Teilgraphen eingefügt werden. Damit kann insbesondere ein Zugriff auf vertrauliche Planungsdaten auf berechtigte, dh. einer entsprechenden Rolle zugeordnete Nutzer oder Applikationen unter Beibehaltung einer Verlinkungsstruktur des Knowledge-Graphen eingeschränkt werden.

Gemäß einer weiteren vorteilhaften Ausführungsform der Erfindung können Bauwerkselementangaben einem Bauwerkselementtyp zugeordnet sein. Einem Bauwerkselementtyp zugeordnete Bauwerkselementangaben können dann einer Rolle zugeordnet werden, indem dieser Bauwerkselementtyp dieser Rolle zugeordnet wird. Auf diese Weise lassen sich Rollen indirekt über Bauwerkselementtypen mehreren Bauwerkselementangaben parallel zuordnen. Insbesondere können so Eigenschaften oder Funktionen von Bauwerkselementen durch einen Bauwerkselementtyp zusammenfasst werden, wodurch sich eine Rollenzuordnung in der Regel erheblich vereinfacht.

Weiterhin kann eine Typ-Beziehungsangabe über eine Beziehung zwischen verschiedenen Bauwerkselementtypen eingelesen werden. Anhand der Typ-Beziehungsangabe können dann Beziehungsangaben über Beziehungen zwischen Bauwerkselementen, die den verschiedenen Bauwerkselementtypen zugeordnet sind, gespeichert werden. Auf diese Weise kann eine Vielzahl von Einzelbeziehungen zwischen Bauwerkselementen in generischer Form zusammenfasst und verwendet werden.

Darüber hinaus kann abhängig vom Bauwerkselementtyp einer jeweiligen Bauwerkselementangabe eine weitere Bauwerkselementangabe und/oder eine weitere Beziehungsangabe aus einer Datenbank eingelesen und der jeweiligen Bauwerkselementangabe oder Beziehungsangabe zugeordnet gespeichert werden. Auf diese Weise können zusätzliche typspezifische Angaben über Eigenschaften, Funktionen oder Darstellungen von Bauwerkselementen als weitere Bauwerkselementangaben eingelesen werden, um so den Knowledge-Graphen zu erweitern.

Nach einer vorteilhaften Weiterbildung der Erfindung kann abhängig vom Bauwerkselementtyp einer jeweiligen Bauwerkselementangabe eine Verknüpfung dieser Bauwerkselementangabe mit einem ausführbaren Programm oder mit einem Zugriffscode erzeugt werden. Die Verknüpfung kann dann in die rollenspezifische digitale Modellansicht übernommen werden, sofern die jeweilige Bauwerkselementangabe selektiert wird. Auf diese Weise können die Nutzungsmöglichkeiten der generierten Modellansichten um rollenspezifische Sicherheits- und Ausführungsaspekte erweitert werden.

Nach einer weiteren vorteilhaften Ausführungsform der Erfindung kann einer oder mehreren vorgegebenen Rollen jeweils ein rollenspezifisches Simulationsverfahren zum Simulieren eines Bauwerksverhaltens anhand des digitalen Bauwerksmodells zugeordnet sein. In diesem Fall kann ein der ermittelten Rolle zugeordnetes, rollenspezifisches Simulationsverfahren selektiert und ausgeführt werden. Abhängig vom simulierten Bauwerksverhalten können dann gespeicherte Bauwerkselementangaben als rollenspezifische Bauwerkselementangaben selektiert werden. So kann beispielsweise für einen Baugutachter ein für dessen Rolle spezifisches Simulationsverfahren ausgeführt werden, das Beschädigungen durch Feuer, Sturm oder Wasser simuliert und spezifisch beschädigungsanfällige Bauwerkselemente für die rollenspezifische Modellansicht selektiert.

Gemäß einer weiteren vorteilhaften Ausführungsform der Erfindung können bei Anforderung einer Modellansicht mehrere Bauwerkselementtypen über eine Benutzerschnittstelle zur Auswahl angezeigt werden, um einen über die Benutzerschnittstelle ausgewählten Bauwerkselementtyp einer der Anforderung zugeordneten Rolle zuzuordnen. Bei einer späteren Anforderung einer Modellansicht kann dann ein Bauwerkselementtyp, der häufiger ausgewählt wurde als ein anderer Bauwerkselementtyp, gegenüber dem anderen Bauwerkselementtyp bevorzugt zur Auswahl angezeigt oder ohne Benutzerinteraktion einer Rolle zugeordnet werden. Auf diese Weise kann eine zunehmend automatische Zuordnung von Rollen zu Bauwerkselementtypen im Rahmen einer einfachen Benutzung der Erfindung erlernt werden.

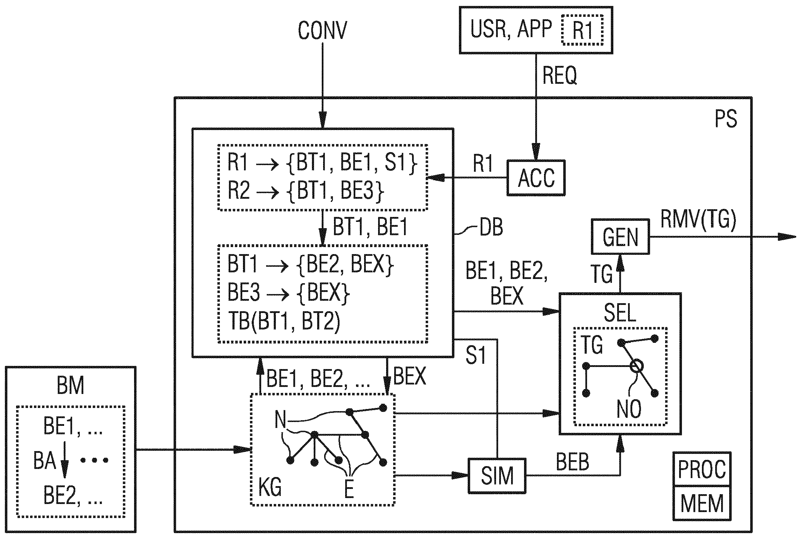

Ein Ausführungsbeispiel der Erfindung wird nachfolgend anhand der Zeichnung näher erläutert.
Die Figur zeigt ein Planungssystem zum Generieren von digitalen Modellansichten in schematischer Darstellung.

In der Figur ist ein Planungssystem PS als erfindungsgemäße Vorrichtung zum Generieren von digitalen Modellansichten für Bauwerke schematisch dargestellt. Die Bauwerke können beispielsweise Wohngebäude, Bürogebäude, Fabrikgebäude, Kraftwerke, Tunnel, Brücken, Straßen oder andere bauliche Konstruktionen sein.

Das Planungssystem PS verfügt über einen Prozessor PROC zum Ausführen von Verfahrensschritten des erfindungsgemäßen Verfahrens sowie über einen mit dem Prozessor PROC gekoppelten Speicher MEM zum Speichern von zu verarbeitenden Daten.

Die Modellansichten RMV werden durch das Planungssystem PS anhand eines digitalen Bauwerksmodells BM generiert, dass das betreffende Bauwerk beschreibt. Das Bauwerksmodell BM kann vorzugsweise ein sogenanntes BIM-Modell (BIM: Building Information Model) oder ein anderes CAD-Modell des Bauwerks sein. Durch das Bauwerksmodell BM wird eine Vielzahl von Bauwerkselementen des Bauwerks, wie z.B. Wände, Decken, Böden, Fenster, Türen, Treppen und/oder andere spezifische Konstruktionselemente in maschinenlesbarer Form durch eine Vielzahl von Bauwerkselementangaben beschrieben. Letztere können im Bauwerksmodell BM durch spezifische Datensätze dargestellt werden. Aus Übersichtlichkeitsgründen sind in der Figur nur Bauwerkselementangaben BE1 und BE2 des Bauwerksmodells BM explizit dargestellt.

Das Bauwerksmodell BM beschreibt weiterhin auch eine Vielzahl von Beziehungen zwischen Bauwerkselementen bzw. Bauwerkselementangaben, hier BE1 und BE2 durch entsprechende Beziehungsangaben BA. Durch derartige Beziehungsangaben BA können z.B. Türen oder Fenster jeweils derjenigen Wand zugeordnet werden, in die die betreffende Türe bzw. das betreffende Fenster planungsgemäß einzusetzen ist. Auch die Beziehungsangaben BA können im Bauwerksmodell BM durch spezifische Datensätze dargestellt werden, die den entsprechenden Bauwerkselementangaben, hier BE1 und BE2 zugeordnet sind.

Aus einem digitalen Bauwerksmodell lassen sich die vorstehenden Angaben in der Regel auf einfache Weise extrahieren. Aus einem nicht digitalen Bauplan kann ein für die Erfindung geeignetes digitales Bauwerksmodell erzeugt werden, indem der Bauplan eingescannt wird, und mittels eines Mustererkennungsverfahrens Bauwerkselemente und deren Beziehungen im eingescannten Bauplan identifiziert werden. Zur Identifizierung können grafische Elemente des Bauplans mit vorgegebenen grafischen Mustern, z.B. durch Ähnlichkeitsvergleich korreliert werden. Die identifizierten Bauwerkselemente und ihre Beziehungen können dann in Form von maschinenlesbaren Bauwerkselementangaben und Beziehungsangaben in einem digitalen Bauwerksmodell gespeichert werden. Alternativ oder zusätzlich kann ein geeignetes digitales Bauwerksmodell auch aus einem zweidimensionalen oder dreidimensionalen Scan eines realen Bauwerks abgeleitet werden.

Das Planungssystem PS weist eine Datenbank DB auf, in der vorgegebenen Bauwerkselementangaben weitere Bauwerkselementangaben und weitere Beziehungsangaben über Beziehungen zwischen Bauwerkselementen zugeordnet sind. Im vorliegenden Ausführungsbeispiel sind einer Bauwerkselementangabe BE3 in der Datenbank DB weitere Bauwerkselementangaben BEX zugeordnet. Auf diese Weise können beliebigen durch eine Bauwerkselementangabe beschriebenen Bauwerkselementen weitere Bauwerkselementangaben über dessen Eigenschaften, Funktion oder Darstellung gespeichert werden. Insbesondere können zu einem Bauwerkselement auch unterschiedliche Darstellungsvarianten oder Realisierungsvarianten gespeichert werden, beispielsweise verschiedene Texturen zur grafischen Darstellung einer Wand, akustische Abstandsanzeigen für Sehbehinderte oder verschiedene Detailstufen einer Darstellung. Anhand von unterschiedlichen Detailstufen zur Darstellung von Bauwerkselementen können insbesondere unterschiedliche Zugriffsrechte implementiert werden.

Darüber hinaus können in der Datenbank DB auch Bauwerkselementtypen gespeichert werden, denen dort jeweils unterschiedliche Bauwerkselementangaben zugeordnet sein können. Im vorliegenden Ausführungsbeispiel sind einem generischen Bauwerkselementtyp BT1 in der Datenbank DB die Bauwerkselementangaben BE2 und BEX zugeordnet. Derartige Bauwerkselementtypen können insbesondere spezifisch für einen jeweiligen Benutzer oder einen Zweck der zu generierenden Modellansicht vorgesehen sein. So kann beispielsweise ein jeweiliger Bauwerkselementtyp spezifisch für alle für Feuerschutz, Gebäudereinigung, Möblierung, Mobilfunkabdeckung bzw. Logistik relevanten Bauwerkselemente vorgesehen und diesen in der Datenbank DB zugeordnet sein. Weiterhin können auch Bauwerkselementtypen für spezifische Eigenschaften, Funktionen, Sonderausführungen oder Darstellungen von Bauwerkselementen vorgesehen sein. Darüber hinaus können verschiedene Bauwerkselementtypen für verschiedene Darstellungsweisen von Bauwerkselementen hinsichtlich Größe, Farbe oder Linienstärke oder für akustische Ausgaben für sensorisch eingeschränkte Personen definiert werden. Die Bauwerkselementtypen können insbesondere auch hierarchisch organisiert sein, d.h. mehrere Bauwerkselementtypen können ihrerseits einem übergeordnetem Bauwerkselementtyp zugeordnet und dadurch zusammengefasst werden.

Weiterhin sind in der Datenbank DB Typ-Beziehungsangaben TB gespeichert, die jeweils eine Beziehung zwischen verschiedenen Bauwerkselementtypen angeben. Im vorliegenden Ausführungsbeispiel enthält die Datenbank DB eine Typ-Beziehungsangabe TB über eine generische Beziehung zwischen den Bauwerkselementtypen BT1 und BT2. Eine derartige Typ-Beziehungsangabe kann z.B. angeben, dass ein Bauwerkselement vom Typ "Türe" in einem Bauwerkselement vom Typ "Wand" angeordnet ist.

Erfindungsgemäß werden durch das Planungssystem PS bei der Generierung der Modellansichten RMV verschiedene Rollen von Benutzern oder Applikationen berücksichtigt. Eine jeweilige Rolle dient hierbei zur Bündelung von Rechten, Funktionen oder Eigenschaften von Benutzern oder Applikationen. Eine einem Benutzer zugeordnete Rolle wird häufig auch als Benutzerrolle bezeichnet.

Eine jeweilige Rolle kann insbesondere Zugriffsrechte, Zweck oder Anlass einer zu generierenden Modellansicht RMV betreffen. So können spezifische Rollen abhängig von einer Funktion eines jeweiligen Benutzers oder einer jeweiligen Applikation vorgesehen sein. Weiterhin können Rollen abhängig von einem Zweck einer Anforderung einer Modellansicht spezifiziert werden, wie z.B. für Brandschutz, Gebäudelogistik, Inventarisierung, Gebäudereinigung oder Elektroinstallation. Spezifische Rollen können insbesondere für Ersteller oder Benutzer von Fluchtplänen, Reinigungsplänen, Belegungsplänen, Brandschutzplänen, Mobiliarplänen, Roboterwegen, Energiesimulationen oder zur Beurteilung einer Mobilnetz- oder WLAN-Abdeckung vorgesehen sein.

Den Rollen werden jeweils ein oder mehrere Bauwerkselementangaben direkt oder indirekt zugeordnet. So können z.B. einer für Brandschutz oder für Brandschutzbeauftragte vorgesehenen Rolle neben für Fluchtwege relevanten Bauwerkselementangaben auch Angaben über Feuerlöscher zugeordnet werden.

Im vorliegenden Ausführungsbeispiel sind in der Datenbank DB benutzer- oder applikationsspezifische Rollen R1 und R2 gespeichert. Dabei ist die Rolle R1 dem Bauwerkselementtyp BT1 und der Bauwerkselementangabe BE1 und die Rolle R2 dem Bauwerkselementtyp BT1 und der Bauwerkselementangabe BE3 zugeordnet. Der Rolle R1 sind also die Bauwerkselementangabe BE1 direkt und die Bauwerkselementangaben BE2 und BEX indirekt über den Bauwerkselementtyp BT1 zugeordnet. Entsprechend sind der Rolle R2 die Bauwerkselementangabe BE3 direkt und die Bauwerkselementangaben BE2 und BEX indirekt zugeordnet.

Darüber hinaus ist der Rolle R1 in der Datenbank DB noch ein Verweis S1 auf ein rollenspezifisches Simulationsverfahren zugeordnet. Das Simulationsverfahren dient hierbei zum Simulieren eines Bauwerksverhaltens anhand eines digitalen Bauwerksmodells, hier BM.

Unterschiedliche Rollen können gegebenenfalls hierarchisch, insbesondere in einem Hierarchiebaum organisiert sein, so dass einer jeweiligen Rolle auch Rechte, Funktionen oder Eigenschaften von hierarchisch höherstehenden Rollen zugerechnet werden.

Die oben genannten Bauwerkselementangaben, Beziehungsangaben, Bauwerkselementtypen, Typ-Beziehungsangaben und Rollen sowie deren Zuordnungen werden vorzugsweise im Rahmen einer Konfiguration CONV des Planungssystems PS in der Datenbank DB gespeichert.

Im vorliegenden Ausführungsbeispiel wird das Bauwerksmodell BM durch das konfigurierte Planungssystem PS eingelesen, das die im Bauwerksmodell BM enthaltenen Bauwerkselementangaben BE1, BE2,... sowie die Beziehungsangaben BA über Beziehungen zwischen den betreffenden Bauwerkselementen extrahiert. Anhand des Bauwerksmodells BM wird ein sogenannter Knowledge-Graph KG aufgebaut und mit aus dem Bauwerksmodell BM extrahierten Angaben vorbelegt. Der Knowledge-Graph KG ist als Datenstruktur implementiert, die eine Vielzahl von Datensätzen zusammen mit den zwischen diesen Datensätzen bestehenden Beziehungen darstellt. Die Datensätze werden hierbei als Knoten und die paarweisen Beziehungen zwischen jeweils zwei Knoten als Kanten bezeichnet.

Im vorliegenden Ausführungsbeispiel werden im Knowledge-Graphen KG die extrahierten Bauwerkselementangaben BE1, BE2,... als Knoten N und die Beziehungsangaben BA als Kanten E gemäß ihrer jeweiligen Zuordnung gespeichert. Eine jeweilige Kante E zwischen zwei Knoten N repräsentiert hierbei eine Beziehung zwischen den durch diese Knoten N repräsentierten Bauwerkselementen. Dies kann beispielsweise eine Zuordnung einer Türe zu einer Wand sein. Aus Übersichtlichkeitsgründen sind in der Figur nur eine Auswahl von Knoten und Kanten des Knowledge-Graphen KG mit einem Bezugszeichen versehen.

Alternativ oder zusätzlich zum Knowledge-Graphen KG kann zur Speicherung der aus dem Bauwerksmodell BM extrahierten Daten auch ein anderes Zwischenformat verwendet werden, das die genannten Zuordnungen darstellen kann und mit dessen Datenelementen weitere Daten verknüpft werden können.

Für den mit den Angaben aus dem Bauwerksmodell BM vorbelegten Knowledge-Graphen KG wird anschließend geprüft, ob zu einer jeweiligen dort gespeicherten Bauwerkselementangabe BE1, BE2,... oder Beziehungsangabe BA eine weitere Bauwerkselementangabe und/oder eine weitere Beziehungsangabe in der Datenbank DB hinterlegt ist. Weiterhin wird geprüft, ob zum Bauwerkselementtyp einer im Knowledge-Graphen KG gespeicherten Bauwerkselementangabe BE1, BE2,... eine weitere Bauwerkselementangabe oder Beziehungsangabe in der Datenbank DB hinterlegt ist. Im vorliegenden Ausführungsbeispiel wird dabei ermittelt, dass die im Knowledge-Graphen KG gespeicherte Bauwerkselementangabe BE2 dem Bauwerkselementtyp BT1 zugeordnet ist, dem seinerseits die weiteren Bauwerkselementangaben BEX zugeordnet sind. Infolgedessen werden die weiteren Bauwerkselementangaben BEX aus der Datenbank DB ausgelesen und der jeweiligen Bauwerkselementangabe BE2 zugeordnet als Knoten N im Knowledge-Graphen KG gespeichert. Der Knowledge-Graph KG wird hierdurch an der jeweiligen Stelle der Bauwerkselementangabe BE2 mit den weiteren Bauwerkselementangaben BEX erweitert, d.h. gegenüber dem Bauwerksmodell BM mit Zusatzangaben angereichert.

Die vorstehend beschriebenen Zuordnungen einer jeweiligen Bauwerkselementangabe zu einer jeweiligen weiteren Bauwerkselementangabe kann insbesondere durch eine zusätzliche Beziehungsangabe bzw. Kante E im Knowledge-Graphen KG dargestellt werden.

Darüber hinaus wird geprüft, ob zu Bauwerkselementtypen von im Knowledge-Graphen KG gespeicherten Bauwerkselementangaben eine Typ-Beziehungsangabe TB über eine generische Beziehung zwischen diesen Bauwerkselementtypen in der Datenbank DB hinterlegt ist. Sofern eine solche Typ-Beziehungsangabe TB gefunden wird, können gemäß der gefundenen Typ-Beziehungsangabe TB weitere Beziehungsangaben über Beziehungen zwischen Bauwerkselementen, die den verschiedenen Bauwerkselementtypen zugeordnet sind, im Knowledge-Graphen KG gespeichert werden.

Durch die in der Datenbank DB gespeicherten direkten oder indirekten Zuordnungen von Bauwerkselementangaben zu Rollen werden im Knowledge-Graphen KG gespeicherte Bauwerkselementangaben zumindest implizit einer jeweiligen Rolle zugeordnet. So sind im vorliegenden Ausführungsbeispiel die Knoten BE1, BE2 und BEX des Knowledge-Graphen KG der Rolle R1 und die Knoten BE2, BE3 und BEX der Rolle R2 zugeordnet.

Die Konfiguration CONV, die Vorbelegung des Knowledge-Graphen KG, dessen Erweiterung mit Zusatzangaben aus einer oder mehreren Datenquellen sowie die Zuordnung der Rollen müssen im vorliegenden Ausführungsbeispiel nur einmal initial durchgeführt werden. Anhand des so erzeugten Knowledge-Graphen KG lassen sich dann auf eine jeweilige Anforderung hin eine Vielzahl unterschiedlicher, rollenspezifischer Modellansichten RMV generieren.

Für das vorliegende Ausführungsbeispiel sei angenommen, dass ein Benutzer USR oder eine Applikation APP eine digitale Modellansicht RMV anfordert. Dem Benutzer USR bzw. der Applikation APP sei hierbei die Rolle R1 zugeordnet. Zur Anforderung der Modellansicht RMV wird eine entsprechende Anforderungsnachricht REQ vom Benutzer USR bzw. der Applikation APP an eine Zugriffssteuerung ACC des Planungssystems PS übermittelt. Die Zugriffssteuerung ACC prüft die Anforderungsnachricht REQ und ermittelt dabei die dem Benutzer USR bzw. der Applikation APP und damit der Anforderung zugeordnete Rolle, hier R1.

Die ermittelte Rolle R1 wird von der Zugriffssteuerung ACC zur Datenbank DB übertragen. Anhand der in der Datenbank DB gespeicherten Zuordnungen werden dann abhängig von der ermittelten Rolle R1 diejenigen Bauwerkselementangaben als rollenspezifische Bauwerkselementangaben ermittelt, die dieser Rolle R1 direkt oder indirekt zugeordnet sind. Im vorliegenden Ausführungsbeispiel sind dies die Bauwerkselementangaben BE1, BE2 und BEX. Weiterhin wird der der Rolle R1 zugeordnete Verweis S1 auf das für die Rolle R1 spezifische Simulationsverfahren ermittelt.

Die rollenspezifischen Bauwerkselementangaben BE1, BE2 und BEX werden von der Datenbank DB zu einem Selektionsmodul SEL des Planungssystems PS übermittelt. Zu diesem Selektionsmodul SEL wird auch der erweiterte Knowledge-Graph KG übertragen. Das Selektionsmodul SEL dient zum Selektieren derjenigen im Knowledge-Graphen KG gespeicherten Bauwerkselementangaben, hier BE1, BE2 und BEX, die der ermittelten Rolle, hier R1 zugeordnet sind.

Darüber hinaus wird der der Rolle R1 zugeordnete Verweis S1 auf das rollenspezifische Simulationsverfahren von der Datenbank DB zu einem Simulationsmodul SIM übermittelt. Zu letzterem wird auch der Knowledge-Graph KG übertragen. Das Simulationsmodul SIM dient zum Simulieren eines dynamischen oder statischen Verhaltens des betreffenden Bauwerks. Das Simulationsmodul SIM selektiert das durch den Verweis S1 identifizierte Simulationsverfahren und führt dieses basierend auf den im Knowledge-Graphen KG hinterlegten Bauwerksdaten aus. Abhängig vom simulierten Bauwerksverhalten werden dann davon betroffene Bauwerkselemente ermittelt und Bauwerkselementangaben BEB über diese Bauwerkselemente vom Simulationsmodul SIM zum Selektionsmodul SEL übermittelt.

Durch das für die Rolle R1 spezifische Simulationsverfahren kann insbesondere ein rollenspezifisches Bauwerksverhalten simuliert werden, wie beispielsweise eine Ausbreitung von Feuer, Rauch oder Wasser und/oder eine Beschädigung des Bauwerks durch Feuer, Sturm, Wasser oder andere Einflüsse. So kann z.B. einer für Baugutachter vorgesehenen Rolle ein Simulationsverfahren zugeordnet werden, durch das bestimmte Ereignisse, z.B. ein Einrammen von Pfahlgründungen in der Nähe des Bauwerks und dadurch eventuell hervorgerufene Beschädigungen simuliert werden. In diesen Fällen können selektiv diejenigen Bauwerkselemente ermittelt werden, die mit einer vorgegebenen Wahrscheinlichkeit beschädigt werden.

Darüber hinaus können auch rollenspezifische Simulationsverfahren zur Personenstromsimulation vorgesehen sein. Auf diese Weise können für gehbehinderte Personengruppen oder für Rollstuhlfahrer selektiv geeignete Treppen, Rampen oder Lifte ermittelt werden.

Anhand der übermittelten Bauwerkselementangaben selektiert das Selektionsmodul SEL diejenigen im Knowledge-Graphen KG gespeicherten Bauwerkselementangaben, die der ermittelten Rolle, hier R1, zugeordnet sind. Im vorliegenden Ausführungsbeispiel werden so die Bauwerkselementangaben BE1, BE2, BEX und BEB als rollenspezifische Bauwerkselementangaben im Knowledge-Graphen KG selektiert.

Anschließend wird durch das Selektionsmodul SEL ein nur die selektierten, rollenspezifischen Bauwerkselementangaben BE1, BE2, BEX und BEB und die diesen zugeordneten Beziehungsangaben enthaltender Teilgraph TG des Knowledge-Graphen KG erzeugt. Dabei wird geprüft, ob einer im Teilgraphen TG enthaltenen Beziehungsangabe eine nichtselektierte Bauwerkselementangabe zugeordnet ist. Falls dies zutrifft, wird anstelle des Knotens mit der nichtselektierten Bauwerkselementangabe ein Knoten N0 ohne die nichtselektierte Bauwerkselementangabe in den Teilgraphen TG eingefügt. Der Knoten N0 kann insbesondere ein nur weiterführende Links zu anderen Knoten enthaltender, ansonsten aber leerer oder zumindest informationsreduzierter Knoten sein. Mittels derartiger informationsreduzierter Knoten N0 kann auf einfache Weise z.B. ein Zugriff auf vertrauliche Planungsdaten auf berechtige Nutzer oder Applikationen unter Beibehaltung einer Verlinkungsstruktur des Knowledge-Graphen KG eingeschränkt werden. Darüber hinaus können für einen bestimmten Zweck unwichtige Bauwerkselementangaben weggelassen und so eine resultierende Modellansicht RMV unter Beibehaltung einer Verlinkungsstruktur vereinfacht werden.

Der vom Selektionsmodul SEL erzeugte Teilgraph TG wird zu einem Modellansichtsgenerator GEN des Planungssystems PS übermittelt. Der Modellansichtsgenerator GEN dient zum Generieren einer digitalen Modellansicht RMV aus dem Teilgraphen TG. Hierbei wird der Teilgraph TG durch den Modellansichtsgenerator GEN derart in die Modellansicht RMV umgesetzt, dass die durch Knoten des Teilgraphen TG repräsentierten Bauwerkselementangaben sowie deren durch Kanten repräsentierten Beziehungen durch die Modellansicht RMV vorzugsweise in einem standardisierten Format dargestellt werden. Die digitale Modellansicht RMV kann insbesondere in Form einer Datenstruktur mit Angaben über visuell, akustisch und/oder haptisch wiederzugebende Bauwerksstrukturen generiert werden.

Darüber hinaus kann abhängig vom Bauwerkselementtyp einer jeweiligen selektierten Bauwerkselementangabe eine Verknüpfung dieser Bauwerkselementangabe mit einem ausführbaren Programm oder mit einem Zugriffscode durch den Modellansichtsgenerator GEN erzeugt und in die Modellansicht RMV übernommen werden. Die Verknüpfung zu einem Programm kann dabei vorzugsweise derart in die Modellansicht RMV übernommen werden, dass das Programm durch Aktivieren der Verknüpfung, z.B. durch Mausklick, ausgeführt werden kann. Auf diese Weise können in die Modellansicht RMV Schaltflächen integriert werden, durch die beispielsweise Jalousien, Beleuchtungselemente oder Heizungen im Modell gesteuert werden können. In die Modellansicht RMV integrierte Zugriffscodes können gegebenenfalls zeitabhängig oder nur in einem vorgegeben Zeitfenster verfügbar sein.

Die Erfindung erlaubt eine automatische Anpassung von Modellansichten an ganze Bündel von benutzerspezifischen oder applikationsspezifischen Rechten, Funktionen oder Eigenschaften. Auf diese Weise können die generierten Modellansichten mit geringem Aufwand und in flexibler Weise an ganz unterschiedliche Nutzergruppen oder Anwendungen angepasst werden. Die Zuordnung der Rollen sowie die Aufbereitung der Bauwerkselementangaben und Beziehungsangaben müssen dabei in der Regel nur einmal initial durchgeführt werden. Dabei können verschiedene Angaben aus mehreren unterschiedlichen Datenbanken oder Systemen an einer zentralen Stelle, hier im Knowledge-Graphen KG oder in einem anderen Zwischenformat verknüpft werden. Hieraus kann dann eine konsistente rollenspezifische Sicht der Bauwerksdaten für eine spezifische Benutzergruppe oder Applikation automatisch generiert werden. Die rollenspezifischen Modellansichten können in vielen Fällen ad hoc generiert werden und sind dann sofort verfügbar, z.B. wenn ein Benutzer ein Gebäude betritt.

## Patentansprüche

1. Computerimplementiertes Verfahren zum Generieren von digitalen Modellansichten (RMV) für ein Bauwerk, wobei
a) ein digitales Bauwerksmodell (BM) des Bauwerks eingelesen wird,
b) aus dem digitalen Bauwerksmodell (BM) Bauwerkselementangaben (BE1, BE2) über Bauwerkselemente und Beziehungsangaben (BA) über Beziehungen zwischen Bauwerkselementen extrahiert und gemäß einer jeweiligen Beziehung einander zugeordnet gespeichert werden,
c) unterschiedlichen, zur Bündelung von Rechten, Funktionen oder Eigenschaften von Benutzern (USR) oder Applikationen (APP) vorgesehenen Rollen (R1, R2) jeweils eine oder mehrere Bauwerkselementangaben (BE1, BE22) zugeordnet werden,
d) bei Anforderung einer Modellansicht (RMV) eine der Anforderung zugeordnete Rolle (R1) ermittelt wird,
e) diejenigen gespeicherten Bauwerkselementangaben (BE1, BE2) als rollenspezifische Bauwerkselementangaben selektiert werden, die der ermittelten Rolle (R1) zugeordnet sind, und
f) mit den selektierten, rollenspezifischen Bauwerkselementangaben (BE1, BE2) und den diesen zugeordneten Beziehungsangaben eine rollenspezifische digitale Modellansicht (RMV) generiert und ausgegeben wird.

2. Verfahren nach Anspruch 1, **dadurch gekennzeichnet, dass** geprüft wird, ob zu einer jeweiligen Bauwerkselementangabe (BE1, BE2) oder Beziehungsangabe (BA) eine weitere Bauwerkselementangabe (BEX) und/oder eine weitere Beziehungsangabe in einer Datenbank (DB) hinterlegt ist, und falls dies zutrifft, die weitere Bauwerkselementangabe (BEX) und/oder weitere Beziehungsangabe eingelesen und der jeweiligen Bauwerkselementangabe (BE1, BE2) oder Beziehungsangabe (BA) zugeordnet gespeichert wird.

3. Verfahren nach einem der vorhergehenden Ansprüche, **dadurch gekennzeichnet, dass**
die Bauwerkselementangaben (BE1, BE2) als Knoten (N) und die Beziehungsangaben (BA) als Kanten (E) in einem Knowledge-Graphen (KG) gespeichert werden.

4. Verfahren nach einem Anspruch 3, **dadurch gekennzeichnet, dass** ein die selektierten, rollenspezifischen Bauwerkselementangaben (BE1, BE2) und die diesen zugeordneten Beziehungsangaben enthaltender Teilgraph (TG) des Knowledge-Graphen (KG) erzeugt wird, und
dass die rollenspezifische digitale Modellansicht (RMV) anhand des erzeugten Teilgraphen (TG) generiert wird.

5. Verfahren nach einem Anspruch 4, **dadurch gekennzeichnet, dass** geprüft wird, ob einer im Teilgraphen (TG) enthaltenen Beziehungsangabe eine nichtselektierte Bauwerkselementangabe zugeordnet ist, und falls dies zutrifft, anstelle des Knotens mit der nichtselektierten Bauwerkselementangabe ein Knoten (N0) ohne die nichtselektierte Bauwerkselementangabe in den Teilgraphen (TG) eingefügt wird.

6. Verfahren nach einem der vorhergehenden Ansprüche, **dadurch gekennzeichnet,**
**dass** Bauwerkselementangaben (BE2, BEX) einem Bauwerkselementtyp (BT1) zugeordnet sind, und
**dass** einem Bauwerkselementtyp (BE1) zugeordnete Bauwerkselementangaben (BE2, BEX) einer Rolle (R1, R2) zugeordnet werden, indem dieser Bauwerkselementtyp dieser Rolle zugeordnet wird.

7. Verfahren nach Anspruch 6, **dadurch gekennzeichnet,**
**dass** eine Typ-Beziehungsangabe (TB) über eine Beziehung zwischen verschiedenen Bauwerkselementtypen (BT1, BT2) eingelesen wird, und
**dass** anhand der Typ-Beziehungsangabe (TB) Beziehungsangaben über Beziehungen zwischen Bauwerkselementen, die den verschiedenen Bauwerkselementtypen (BT1, BT2) zugeordnet sind, gespeichert werden.

8. Verfahren nach Anspruch 6 oder 7, **dadurch gekennzeichnet, dass** abhängig vom Bauwerkselementtyp einer jeweiligen Bauwerkselementangabe eine weitere Bauwerkselementangabe und/oder weitere Beziehungsangabe aus einer Datenbank (DB) eingelesen und der jeweiligen Bauwerkselementangabe oder Beziehungsangabe zugeordnet gespeichert wird.

9. Verfahren nach einem der Ansprüche 6 bis 8, **dadurch gekennzeichnet,**
**dass** abhängig vom Bauwerkselementtyp einer jeweiligen Bauwerkselementangabe eine Verknüpfung dieser Bauwerkselementangabe mit einem ausführbaren Programm oder mit einem Zugriffscode erzeugt wird, und
**dass** die Verknüpfung in die rollenspezifische digitale Modellansicht (RMV) übernommen wird, sofern die jeweilige Bauwerkselementangabe selektiert wird.

10. Verfahren nach einem der vorhergehenden Ansprüche, **dadurch gekennzeichnet,**
**dass** einer oder mehreren vorgegebenen Rollen (R1, R2) jeweils ein rollenspezifisches Simulationsverfahren zum Simulieren eines Bauwerksverhaltens anhand des digitalen Bauwerksmodells zugeordnet ist,
**dass** ein der ermittelten Rolle (R1) zugeordnetes, rollenspezifisches Simulationsverfahren selektiert und ausgeführt wird, und
**dass** gespeicherte Bauwerkselementangaben (BEB) abhängig vom simulierten Bauwerksverhalten als rollenspezifische Bauwerkselementangaben selektiert werden.

11. Verfahren nach einem der vorhergehenden Ansprüche, **dadurch gekennzeichnet,**
**dass** bei Anforderung einer Modellansicht (RMV) mehrere Bauwerkselementtypen über eine Benutzerschnittstelle zur Auswahl angezeigt werden,
**dass** ein über die Benutzerschnittstelle ausgewählter Bauwerkselementtyp einer der Anforderung zugeordneten Rolle zugeordnet wird, und
**dass** bei einer späteren Anforderung einer Modellansicht ein Bauwerkselementtyp, der häufiger ausgewählt wurde als ein anderer Bauwerkselementtyp, gegenüber dem anderen Bauwerkselementtyp bevorzugt zur Auswahl angezeigt oder ohne Benutzerinteraktion einer Rolle zugeordnet wird.

12. Verfahren nach einem der vorhergehenden Ansprüche, **dadurch gekennzeichnet, dass**
das digitale Bauwerksmodell (BM) erzeugt wird durch
- Einscannen eines Bauplans und
- Identifizieren von Bauwerkselementen und deren Beziehungen im eingescannten Bauplan mittels eines Mustererkennungsverfahrens.

13. Vorrichtung (PS) zum Generieren von digitalen Modellansichten (RMV) für ein Bauwerk, eingerichtet zum Ausführen eines Verfahrens nach einem der vorhergehenden Ansprüche.

14. Computerprogrammprodukt, eingerichtet zum Ausführen eines Verfahrens nach einem der Ansprüche 1 bis 12.

15. Computerlesbares Speichermedium mit einem Computerprogrammprodukt nach Anspruch 14.
